Europäisches Patentamt

(19) European Patent Office

Office européen des brevets

(11) Publication number: **0 191 165**

**B1**

(12) **EUROPEAN PATENT SPECIFICATION**

(45) Date of publication of patent specification: **24.10.90**

(21) Application number: **85115357.7**

(22) Date of filing: **04.12.85**

(51) Int. Cl.⁵: **H 03 K 19/013, H 03 K 19/088**

(54) Adjustable speed up circuit for TTL-type gates.

(30) Priority: **15.01.85 US 692581**

(43) Date of publication of application:
**20.08.86 Bulletin 86/34**

(45) Publication of the grant of the patent:
**24.10.90 Bulletin 90/43**

(84) Designated Contracting States:
**DE GB IT**

(56) References cited:
**EP-A-0 032 043**
**US-A-4 180 750**
**US-A-4 255 670**

**PATENT ABSTRACTS OF JAPAN, vol. 4, no. 11**
**(E-168), 26th January 1980, page 131 E 168 &**
**JP-A-54-152 955**

(73) Proprietor: **TEXAS INSTRUMENTS**
**INCORPORATED**
**13500 North Central Expressway**
**Dallas Texas 75265 (US)**

(72) Inventor: **Ovens, Kevin M.**
**1218 Mayapple**
**Garland, TX 75043 (US)**

(74) Representative: **Leiser, Gottfried, Dipl.-Ing. et al**
**Patentanwälte Prinz, Leiser, Bunke & Partner**
**Manzingerweg 7**
**D-8000 München 60 (DE)**

Courier Press, Leamington Spa, England.

## Description

### Technical field of the invention

This invention relates to electronic circuitry, and more particularly relates to speed up circuitry wherein the output transition of a TTL-type gate may be selectively adjusted.

The invention relates to a transition speed up circuit as described in the precharacterizing part of claim 1.

### Background of the invention

Many circuits are commonly used for electronic devices wherein it is important that a rapid transition be made from one voltage level to another. For example, output circuits are often used for converting from STL levels of internal logic to TTL levels necessary on circuit output pins. A typical output circuit for a TTL gate might normally have a low voltage level input and a high voltage output. If a high voltage input occurs, it is important that the output circuit provide a very fast transition to a low output. It is also important that such output circuits be able to drive high capacitive loads.

Previously developed output circuits for TTL gates have been developed with "speed up" elements which apply extra speed up current to an output transistor during output transition. However, such prior speed up circuits do not apply speed up current for a sufficiently long time or of a sufficiently high magnitude. Moreover, previously developed speed up circuits have been provided with a fixed threshold voltage for termination of speed up current. A need has thus arisen for a speed up output circuit which not only supplies a speed up current for a substantial period of time in order to provide rapid output transition, but which also allows easy variability of the length of time the turn off current is applied.

A circuit according to the precharacterizing part of claim 1 is disclosed in JP—A—54 152 955. This circuit has a separate terminal for applying a base current used to control the speed up transistor. No circuitry is shown suitable for automatically controlling the speed up transistor in dependence on the input signal applied to the input transistor.

### Summary of the invention

In accordance with the present invention, the transition speed up circuit which substantially eliminates or minimizes the problems associated with previously developed output speed up circuits includes the features of the characterizing part of claim 1.

Preferred embodiments of the invention are defined in the subclaims.

### Brief description of the drawings

For a more detailed explanation of the present invention and for further objects and advantages thereof, reference is now made to the following drawings, taken in conjunction with the accompanying description:

Figure 1 illustrates the circuitry of a prior art speed up circuit for use with a TTL gate; and

Figure 2 is a schematic circuit of the preferred embodiment of the present improved speed up circuit.

### Detailed description of the invention

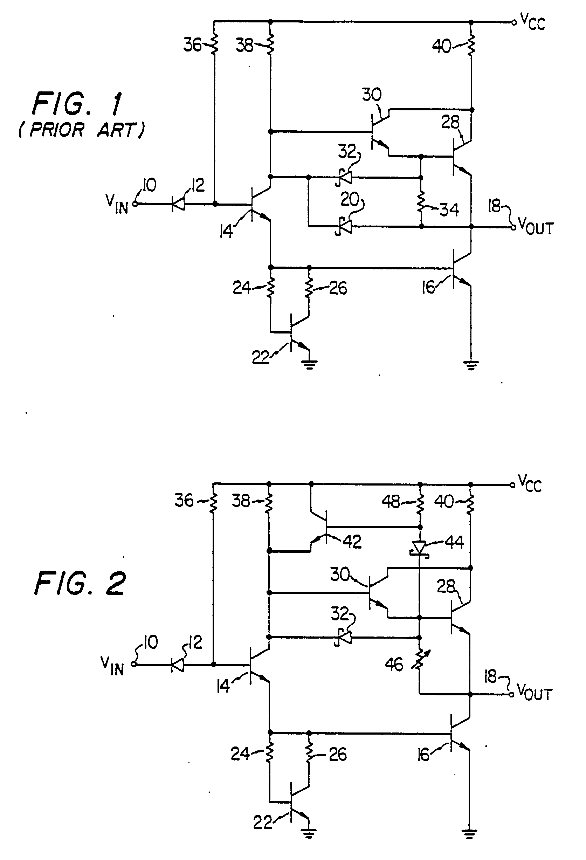

Figure 1 is a schematic diagram of a prior art speed up circuit. A high or low voltage at input terminal 10 is applied through a diode 12 to the base of an input transistor 14. The emitter of input transistor 14 is connected to the base of an output transistor 16. The collector of transistor 16 is connected to an output terminal 18 to provide a desired output voltage to TTL circuitry.

A speed up Schottky diode 20 is connected between the collectors of input transistor 14 and output transistor 16. Diode 20 provides additional or speed up current to the base of the output transistor 16 through input transistor 14 during turn on, to cause transistor 16 to become conductive more rapidly in response to voltage transitions received at input voltage terminal 10.

As the prior art circuit of Figure 1 is often driven by STL gates which have insufficient drive, an active turn off transistor 22 may be connected through resistors 24 and 26 to the base of output transistor 16. Also, as a part of a typical turn off circuit, a Darlington pair transistor configuration is provided which includes a transistor 28 connected at its emitter to the output terminal 18 and a transistor 30 connected across the base and collector of transistor 28. A Schottky diode 32 is connected between the emitter of transistor 30 and the collector of input transistor 14. A resistor 34 is connected between the anodes of diodes 20 and 32. Resistors 36, 38 and 40 provide suitable biasing to the transistors of the circuit.

In operation of the prior art circuit of Figure 1, assume that the input voltage applied to terminal 10 is low and the output voltage at terminal 18 is high. Transistors 14, 16 and 22 are thus nonconductive. When the input voltage applied to terminal 10 transitions to a high state, the transistor 14 becomes conductive and applies current from its emitter to the base of the output transistor 16. In addition, speed up base current is applied to output transistor 16 through transistor 14 from diode 20, which also begins conduction. In response to the base current, the output transistor 16 begins to conduct, and the output voltage at terminal 18 begins to drop until finally diode 20 stops conduction. This reduces the initial speed up current applied to the base of transistor 16. At this point, the only source of turn on current being applied to output transistor 16 is through the resistor 38 source and transistor 14.

It may be shown that diode 20 terminates conduction when the output voltage at terminal 18 equals the base-emitter voltage of output transistor 16 plus the on voltage of input transistor 14 plus the diode voltage of diode 20. Since the on voltage of input transistor 14 approximately equals a transistor base-emitter voltage minus the diode 20 voltage, then the output voltage for turning diode 20 off may be shown to be approximately twice the base-emitter voltage of the output transistor 16. In other words, diode 20 becomes nonconductive and stops applying speed up current when the output voltage at terminal 18 reaches approximately twice the base-emitter voltage of output transistor 16. In a typical circuit, the threshold voltage for termination of turn off current will be approximately 1.7 volts.

This threshold value of prior speed up circuits has been found to be excessively high for optimum performance, as speed up current is not applied long enough to the output transistor 16, thus lengthening the turn off time of the circuit. Moreover, the additional speed up current applied to transistor 16 is limited by the $h_{FE}$ of transistor 14. Since transistor 14 normally supplies turn on current to output transistor 16 through resistor 34, this tends to reduce the additional turn on current available for transistor 16.

Figure 2 illustrates an improved circuit in accordance with the present invention wherein like numerals are used for like and identical components shown in Figure 1. Figure 2 illustrates the voltage input terminal 10, input diode 12 and input transistor 14. Likewise, the emitter of transistor 14 is connected to the base of the output transistor 16, the collector of which is applied to output terminal 18 to provide a voltage output. Transistor 22 is connected at its emitter and collector through resistors 24 and 26 to the base of transistor 16. A Darlington pair formed from transistors 28 and 30 is connected to the collector of transistor 16. Biasing resistors 36, 38 and 40 are connected similarly as in Figure 1.

In Figure 2, however, the speed up diode 20 has been eliminated and replaced by a speed up transistor 42 connected at its emitter to the collector of input transistor 14. The base of transistor 42 is connected to the anode of a Schottky diode 44, the cathode of which is connected to the base of transistor 28 and the anode of diode 32. The cathode of diode 44 is also connected to a variable resistor 46 which is connected directly to output terminal 18. Resistor 46 is illustrated as being variable in order to adjust the turn off termination voltage threshold of the circuit. A resistor 48 is connected between the bias voltage and the base of transistor 42 and the anode of diode 44.

In operation of the improved speed up circuit of Figure 2, assume that the voltage applied to the input terminal 10 is low and the voltage at output terminal 18 is high. Transistors 14, 16, 22 and 42 are nonconductive at this stage. When a high voltage input is applied to the input terminal 10, transistor 14 turns on to supply base drive to transistor 16. Transistor 42 also becomes conductive since the voltage drop across diodes 44 and 32 is insufficient to cause transistor 42 to become nonconductive. The conduction of transistor 42 supplies added or speed up drive current through transistor 14 to the base of transistor 16. This causes transistor 16 to become conductive more rapidly.

As transistor 16 becomes conductive, the voltage at output terminal 18 falls. When the voltage output reaches a threshold determined by the values of the circuit, current through resistor 46 causes the transistor 42 base drive to be diverted and thus renders transistor 42 nonconductive. This terminates the flow of speed up current to transistor 16 and the slope of the output voltage changes to a less rapid turn off slope, since the only remaining base turn off current is generated from transistor 14.

As previously noted with prior art turn off output circuits, the threshold voltage at which the added turn off current was generated occurred at about a voltage output of two base-emitter transistor voltages, or approximately 1.7 volts. With the circuits shown in Figure 2, the voltage threshold at which speed up transistor 42 is rendered nonconductive occurs at:

$$V_T = V_{BE(16)} + V_{ON(14)} + V_{BE(42)} - V_{f(44)} - V_{R(46)}$$

It may be seen that the voltage across resistor 46 may be adjusted to substantially lower the voltage threshold below two base-emitter transistor voltages, thereby representing a substantial improvement in turn off times over prior art devices. For example, if the voltage across resistor 46 is set to be about 0.4 volt, and assuming the base-emitter voltage to transistor 16 to be equal to approximately 0.8 volt, the transistor 14 on voltage to be equal to approximately 0.2 volt and the diode 44 voltage to be approximately 0.6 volt, then the voltage threshold of the circuit is lowered to approximately 0.8 volt, or less than half the threshold voltage of prior art circuits. If diode 44 is converted to a base-emitter diode, the voltage threshold can be lowered even further to approximately 0.6 volt.

An important aspect of the present circuit is that the resistor 46 may be varied in order to change the output threshold level at which speed up current is applied. Consequently, the turn off characteristics of the circuit can be selectively varied.

Although resistor 46 is illustrated with a terminal connected to output terminal 18, it should be understood that the circuit will also operate with the terminal of resistor 46 connected to circuit ground. In addition, a current limiting resistor may be added to the collector of transistor 42, if desired. The circuit of Figure 2 may also be utilized with open collector type output circuits by the utilization of one or two diodes in series to adjust the threshold voltage at which transistor 42 becomes nonconductive.

It may thus be seen that the present invention provides a speed up current for an extended period of time in order to provide a fast transition of an output transistor in a TTL output circuit. The present invention substantially lowers the threshold voltage at which turn off of the speed up device occurs. The utilization of an active gain device such as transistor 42 in place of the previous used diode provides enhanced magnitude of speed up current, thereby further decreasing the turn off time of the circuit. The utilization of the variable resistor 46 enables the turn off characteristics of the circuitry to be selectively varied.

Although the preferred embodiment has been described in detail, it should be understood that various changes, substitutions and alterations can be made therein without departing from the spirit and scope of the invention as defined by the appended claims.

## Claims

1. A transition speed up circuit comprising:
an input transistor (14) for receiving input voltage transitions and for producing a drive current in response thereto;
an output transistor (16) coupled between an output node (18) and ground and to said input transistor (14) and operative to receive the drive current from said input transistor (14) and in response thereto to conduct current from the output node (18) to ground;
a pull up transistor (28) coupled between said output node (18) and a source of high voltage and operative to conduct current from said high voltage source to said output node (18) in response to pull up base current applied to a base thereof;
a current amplifier (30) having an output coupled to a base of said pull up transistor (28) for providing current drive thereto; and
a speed up transistor (42) connected to said input transistor (14) for applying added drive current through said input transistor (14) to said output transistor (16) in response to an input voltage transition, characterized by
a unidirectional conductive element (44) connected from said base of said pull up transistor (28) to the base of said speed up transistor (14), said conductive element (44) applying said added drive current until the output voltage of said output transistor falls to a predetermined voltage level; and
an adjustable conductance path (46) from said base of said pull up transistor (28) to said output node (18) for adjustably establishing the amount by which a final low output voltage level is below said predetermined voltage level.

2. The circuit of claim 1, wherein said adjustable conductance path (46) is a variable resistor.

3. The circuit of claim 2, wherein said current amplifier (30) is a transistor coupled to said pull up transistor (28) so as to form a Darlington pair with an emitter connected to the base of said pull up transistor (28) and a collector connected to a collector of said pull up transistor (28) and a base connected to a collector of said input transistor (14).

4. The circuit of claim 1, wherein said unidirectional conductive element (44) is a Schottky diode.

## Patentansprüche

1. Übergangsbeschleunigungsschaltung mit:
einem Eingangstransistor (14) für den Empfang von Eingangsspannungsübergängen und für die Erzeugung eines Ansteuerstroms in Abhängigkeit davon;
einem zwischen einem Ausgangsschaltungspunkt (18) und Masse liegenden und mit dem Eingangstransistor (14) verbundenen Ausgangstransistor (16), der den Ansteuerstrom von dem Eingangstransistor (14) empfängt und abhängig davon Strom von dem Ausgangsschaltungspunkt (18) nach Masse leitet;
einem Anhebetransistor (28), der zwischen dem Ausgangsschaltungspunkt (18) und einer Hochspannungsquelle liegt und Strom von der Hochspannungsquelle zu dem Ausgangsschaltungspunkt (18) in Abhängigkeit von einem an seine Basis angelegten Anhebe-Basisstrom leitet;
einem Stromverstärker (30) mit einem an die Basis des Anhebetransistors (28) angeschlossenen Ausgang zur Abgabe eines Ansteuerstroms an diese Basis, und
einen Beschleunigungstransistor (42), der an den Eingangstransistor (14) angeschlossen ist und zusätzlichen Ansteuerstrom über den Eingangstransistor (14) an den Ausgangstransistor (16) in Abhängigkeit von einem Eingangsspannungsübergang anlegt, gekennzeichnet durch
ein unidirektionales Leiterelement (44), das von der Basis des Anhebetransistors (28) zur Basis des Beschleunigungstransistors (14) führt, wobei das Leiterelement (44) den zusätzlichen Ansteuerstrom anlegt, bis die Ausgangsspannung des Ausgangstransistors auf einen vorbestimmten Spannungswert fällt; und
einen Weg (46) mit einstellbarem Leitwert von der Basis des Anhebetransistors (28) zu dem Ausgangsschaltungspunkt (18) zum einstellbaren Festlegen des Werts, um den ein niedriger Ausgangsspannungs-Endwert unterhalb dem vorbestimmten Spannungspegel liegt.

2. Schaltung nach Anspruch 1, in welcher der Weg (46) mit einstellbarem Leitwert ein veränderlicher Widerstand ist.

3. Schaltung nach Anspruch 2, bei welcher der Stromverstärker (30) ein Transistor ist, der so mit dem

4

Anhebetransistor (28) verbunden ist, daß ein Darlingtonpaar entsteht, wobei ein Emitter mit der Basis des Anhebetransistors (28) und ein Kollektor mit einem Kollektor des Anhebetransistors (28) und eine Basis mit einem Kollektor des Eingangstransistors (14) verbunden sind.

4. Schaltung nach Anspruch 1, bei welcher das unidirektionale Leiterelement (44) eine Schottky-Diode ist.

**Revendications**

1. Circuit d'accélération de transition comprenant:

—un transistor d'entrée (14) destiné à recevoir des transitions de tension d'entrée et à fournir un courant de commande en réponse à ces dernières;

—un transistor de sortie (16) branché entre un noeud de sortie (18) et la masse et sur ledit transistor d'entrée (14) et agencé pour recevoir le courant de commande provenant dudit transistor d'entrée et pour, en réponse à ce dernier, faire passer du courant du noeud de sortie (18) à la masse;

—un transistor de charge (28) branché entre ledit noeud de sortie (18) et une source de haute tension et agencé pour faire passer du courant de ladite source de haute tension vers ledit noeud de sortie (18) en réponse à un courant de base de charge appliqué sur sa base;

—un amplificateur de courant (30) comportant une sortie relié à une base dudit transistor de charge (28) et destiné à fournir une commande de courant à ce dernier; et

—un transistor d'accélération (42) relié audit transistor d'entrée (14) et destiné à appliquer un courant de commande additionnel à travers ledit transistor d'entrée (14) vers ledit transistor de sortie (16) en réponse à une transition de tension d'entrée, caractérisé par

—un élément conducteur unidirectionnel (44) branché à partir de ladite base dudit transistor de charge (28) vers la base dudit transistor d'accélération (14), ledit élément conducteur (44) appliquant ledit courant de commande additionnel jusqu'à ce que la tension de sortie dudit transistor de sortie tombe à un niveau de tension prédéterminé; et

—un chemin de conductance réglable (46) à partir de la base dudit transistor de charge (28) vers ledit noeud de sortie (18) en vue d'établir de manière réglable la quantité dont un niveau final faible de tension de sortie est inférieur audit niveau de tension prédéterminé.

2. Circuit selon la revendication 1, dans lequel ledit chemin de conductance variable (46) est une résistance variable.

3. Circuit selon la revendication 2, dans lequel ledit amplificateur de courant est un transistor relié audit transistor de charge (28) de manière à former une paire de Darlington avec un émetteur branché à la base dudit transistor de charge (28) et un collecteur relié à un collecteur dudit transistor de charge (28) et une base reliée à un collecteur dudit transistor d'entrée (14).

4. Circuit selon la revendication 1, dans lequel ledit élément conducteur unidirectionnel (44) est une diode Schottky.

FIG. 1
(PRIOR ART)

FIG. 2

1